# EUROPEAN PATENT SPECIFICATION

(11) **EP 0 748 176 B1**
(45) Date of publication and mention of the grant of the patent: **22.04.1998**
(21) Application number: 95911087.5
(22) Date of filing: 23.02.1995
(51) Int. Cl.: A46D 1/00, B24B 29/00, B24D 13/10

(54) **Method for increasing the gloss of a surface**
Verfahren zum Verbessern der Glätte einer Oberfläche
Procede pour ameliorer le poli d'une surface

(30) Priority: 03.03.1994 US 205322
(43) Date of publication of application: 18.12.1996
(73) Proprietor: MINNESOTA MINING AND MANUFACTURING COMPANY, St. Paul, Minnesota 55133-3427 (US)
(72) Inventor: KUBES, Michael, J., Saint Paul, MN 55133-3427 (US); CHOU, Yeun, J., Saint Paul, MN 55133-3427 (US); KOETHE, Charles, G., Saint Paul, MN 55133-3427 (US); HOEPPNER, Harvey, H., Saint Paul, MN 55133-3427 (US)
(74) Representative: Texier, Christian
(86) International application number: US9502261
(87) International publication number: WO9523539

(56) References cited:
- GB-A- 1 093 931
- US-A- 2 958 593
- PATENT ABSTRACTS OF JAPAN vol. 16 no. 304 (C-0959) ,6 July 1992 & JP,A,40 083817 (MITSUBISHI ELECTRIC) 17 March 1992,
- PATENT ABSTRACTS OF JAPAN vol. 14 no. 26 (M-921) ,18 January 1990 & JP,A,12 064777 (ITO KIMIYOSHI) 23 October 1989,

## Description

### Background of the Invention

### 1. Brief Description of the Invention

The present invention relates to surface conditioning methods employing articles made from fibers comprising a thermoplastic polymer having engulfed therein a plurality of microabrasive particles. Particularly described are methods of using such articles for polishing surfaces such as floors.

### 2. Related Art

Abrasive filaments comprising a thermoplastic polymer and abrasive particles engulfed within or adhered to the external surface thereof, such as those known under the trade designation "Tynex", available from DuPont, have myriad uses, one use being disclosed in U.S. Pat. No. 4,305,234 (Pichelman). This reference describes a brush useable with floor maintenance equipment that has both abrasive and polishing qualities. The brush includes a number of tufts of bristles deposited within tuft cavities provided in a base. Each tuft may be comprised of a mixture of abrasive elements such as Tynex A and Tampico. The patentee states that to provide a brush capable of substantially removing scuff marks and the like while simultaneously spreading and buffing a new finish or a work surface without streaking, a mixture of 70% Tynex A and 30% Tampico bristles works well. This reference, however, is devoid of teaching of use of a specific abrasive particle size in the abrasive filaments, or the possible benefits of doing so. It also appears that the abrasive fibers described are employed only for scrubbing/cleaning, while the buffing is performed by the tampico fibers.

U.S. Pat. No.4,037,369 describes a floor maintenance brush or pad having fibers of varying abrasive characteristics, the more abrasive fibers being located toward the center of the brush and the fibers of lesser abrasive characteristics being located toward the outer periphery of the brush. The reference describes brushes incorporating nylon (polyamide) filaments having 120 mesh and 54 mesh abrasive particles therein. The reference mentions at column 3, lines 3-10, a brush constructed with 54 mesh silicon carbide grit in the innermost rows and progressively changing through grit sizes 80, 120, 180, the 320 until the size of 500 was located on the outermost row (thus decreasing in grit size from inner to outer rows). This brush resulted in a large amount of "drag" on the floor machine which can cause an overload on the machine resulting in burnout of motors or blown fuses. The pads are used at low speeds, much lower than the present invention, and it appears the buffing is performed by natural fibers (tampico or bassine) without abrasive particles on or in the fibers. Thus, this reference would appear to teach away from the use of small abrasive particles in abrasive fibers used in floor maintenance operations.

Matsui et al. (U.S. Pat. No. 4,627,950) describes methods of producing abrasive fibers comprising providing a conjugate fiber comprising at least one abrasive layer containing abrasive particles and at least one coating layer substantially covering the abrasive layer, and removing at least a portion of the coating layer from the conjugate fiber with a solvent or a decomposer to expose at least a part of the abrasive layer from the coating. This reference describes fibers having fiber diameter of not more than 200 micrometers, with abrasive particles having diameters roughly one half the diameter of the fibers. The fibers may be used to produce nonwovens, rollers, brushes, and the like.

An important consideration in the floor maintenance industry is that, whatever the machine or abrasive article being used, the user frequently desires a high gloss floor surface. Although the efforts mentioned above are indeed impressive, it is an object of the present invention to provide even higher gloss surfaces using microabrasive filled fibers in surface conditioning products.

In the woodworking art, functional and/or decorative deep cuts or grooves in wood and particle board are problematic from the standpoint of removal of "fuzz" (small wood fibers) from the wood surface, particularly in humid environments. The humidity makes the wood libers stand on end, thus making subsequent uniform staining of the wood difficult due to differential pick-up of stain and lower gloss. There has been a longstanding need in the woodworking art for a nondestructive method of removal of such wood fibers from wood surfaces prior to staining the wood, in other words, a method which will not damage the desired wood surface.

In the printed circuit board art, there is a need for a method of cleaning copper laminates for printed circuit boards which removes undesirable asperities prior to further processing, such as oxide scales and the like. In the metal casting art, such as the jewelry, statuary, and appliance arts, there is generally a cleaning and polishing step after the metal piece is removed from the mold. The state of the art is to use nonwoven abrasive discs of the type described in Hoover et al. (U.S. Pat. No. 2,958,593). Such discs work well on planar or gently-curved surfaces, but suffer in performance when employed against intricate parts having long, narrow protrusions and severe relief. The nonwoven discs tend to fail prematurely due to repeated flexing in confined spaces and suffer high wear due to repeated encounters with acute angles.

GB-A-1 093 931 discloses an abrasive article containing filaments or fibres, which comprise at least two polymer components existing in a sheath and core or side-by-side relationship, one exposed component, the sheath in the case of the sheath and core arrangement, containing uniformly dispersed therein a suitable abrasive material, which should have an average particle size not greater than 10 micons.

### Summary of the Invention

In accordance with the present invention, it has now been discovered that maintenance of floors and other surfaces may be efficiently accomplished while yielding an improved gloss by employing an article comprising a plurality of fibers comprising microabrasive particles dispersed, adhered, and engulfed within a polymeric binder. Articles comprised of such fibers have also been found to be well suited for defuzzing wood, cleaning copper laminate for printed circuit boards, and cleaning intricate metal castings, such as pewter.

Thus, one embodiment of the invention is a method of increasing the gloss of a surface (for example a floor or printed circuit board), the method comprising bringing into frictional contact with the surface an abrasive article comprising a plurality of microabrasive-filled fibers for a time sufficient to increase the gloss of the surface, the fibers each comprising a thermoplastic polymer which has abrasive particles dispersed, adhered and engulfed therein, the fibers comprising:
i) abrasive particles having an average particle size ranging from about 3 to about 10 micrometers for floor polishing ;
ii) each fiber having a length dimension and a transverse cross-section perpendicular to the length dimension, the transverse cross-section having major axis length ranging from about 0.25 to about 0.4 mm.

Another embodiment of the invention is a method of removing undesirable material from a surface which employs articles similar to those described in reference to the first method. In this embodiment, the term "undesirable material" is meant to include wood fibers attached to a wood surface, metal flashing attached to a cast metal part, oxides formed on copper laminate, and the like.

As used herein the term "major axis length" refers to the longest length dimension measurable in the transverse cross-section of each fiber. For example, for fibers having circular cross-section, the major axis length is equal to the fiber diameter and is referred to as such, whereas for rectangular fibers, the major axis length is the length equal to the square root of the sum of the squares of the lengths of one long side and one short side of the rectangle (for rectangles other than squares) or the square root of the sum of the squares of the length of two sides off a square.

The term "microbrasive-filled" means that substantially all of the abrasive particles have 100 percent of their external surface covered by thermoplastic polymer, and that the external surface of the fibers is, for the most part, smooth and continuous in nature, although there may exist some surface irregularities in the external surface of the fibers due to the underlying abrasive particles. Some of the abrasive particles may actually protrude from the external surface of the fiber and be exposed, especially during use of the articles described herein. Further, the fiber tips striking the surface of the workpiece being treated may split during use, in theory due in part to the presence of the abrasive particles, a phenomenon known in the art as "self-flagging", which may be preferred when certain fiber material embodiments are employed. (Flagging may also be achieved on "new" fibers before they are used in the methods of the invention.) For example, it has been determined that initially flagged, hollow, round polyethylene terephthalate (PET) microabrasive-filled fibers give good initial 20° gloss readings in polishing vinyl floors. On the other hand, it has also been found that new, round, solid, unflagged microabrasive fibers employing nylon 6,12 as the thermoplastic material performed as well as the hollow, flagged microabrasive-filled PET fibers.

In all of the abrasive articles described herein as useful in the methods of the invention, the term "microabrasive" means that the abrasive particles have an average particle size less than or equal to about 60 micrometers, but in all cases more than 0.1 micrometer. Fibers employing abrasive particles within this range have proven exceptional for increasing gloss of a variety of surfaces, such as urethane/acrylic floor finishes, marble, ceramic tile, and glass. The abrasive particles may be selected from aluminum oxide, silicon carbide, garnet, ceramic aluminum oxide and particles of like hardness (preferably greater than or equal to 7 Moh).

The transverse cross-sectional shape of microabrasive-filled fibers useful in the invention is not particularly important. The microabrasive-filled fibers useful in the invention may have various transverse cross-sections: square or other rectangular cross-section; lobed arrangements such as tri-lobal, tetralobal, and the like; and other uniform or nonuniform cross-section. The transverse cross-section of the fiber may be constant throughout the length of the fiber, or change within individual fibers, or change from fiber to fiber. Square or other rectangular transverse cross-section fibers (especially polypropylene and polyethylene) may be produced using fibrillated film techniques such as described in Kirk-Othmer, Encyclopedia of Chemical Technology, 3rd Ed., Vol. 16, pages 357-385, particularly pages 375-377. The Nonwovens Handbook, 1988, page 99 discloses that "fibrillation" comprises breaking up of a plastic sheet into a fibrous sheet; the term is also used to denote the process of breaking fibers into smaller fibers. When used herein, "fibrillation" refers to the first usage.

Although the transverse cross-section shape of the fibers is not a critical aspect of the invention, the synergistic combination of length of the major axis of the fibers and the abrasive particle diameter has been found to be critical to polishing (gloss enhancement).

Microabrasive-filled fibers useful in the invention may be solid or hollow, crimped or uncrimped, annealed (i.e., heated to relieve stress) or nonannealed.

Microabrasive-filled fibers useful in the articles of the invention may contain fillers, lubricants, colorants and/or pigments, grinding aids, ultraviolet light stabilizers, and the like in levels typically used in the abrasives art.

The concentration of the abrasive particles in the microabrasive-filled fibers can be as high as 40 percent by weight, but more preferably ranges from about 10 to about 30 percent by weight. The draw ratio of the fiber-making process can be as high as 10 to 1 depending on the polymeric material and the abrasive particle concentration.

Preferred thermoplastic polymers include those selected from the group consisting of polyamide, polypropylene, polyester, and thermoplastic elastomers (such as polyamide, polypropylene and polyester thermoplastic elastomers).

One preferred article for use in the methods of the invention is a lofty, open, three-dimensional nonwoven article comprised of microabrasive-filled fibers. This article differs from those wherein abrasive particles are attached to the fibers by use of an adhesive, as in Hoover et al., mentioned previously. The major axis length dimension for fibers useful in these embodiments ranges from about 0.025 mm to about 0.4 mm, preferably from about 0.05 to about 0.1 mm, while the abrasive particle average diameter ranges from about 1 to about 30 micrometers, preferably from about 3 to about 10 micrometers. The fiber length ranges from about 1.25 to 10 centimeters (cm), lengths of about 3 to about 5 cm being preferred.

A second preferred abrasive article for use in the methods in accordance with the present invention is a tufted abrasive article, wherein a plurality of tufts of microabrasive-filled fibers are attached to a backing. The "tufted abrasive articles" for use in the present invention preferably have a tufted pile face weight of at least about 600 grams per square meter and a pile height (i.e length of fibers above the backing) of at least about 1.0 centimeter, preferably from about 1 to about 5 centimeters, although shorter or longer fibers may be useful in certain applications.

The major axis length of the fibers useful in this aspect of the invention preferably ranges from about 0.05 to about 0.1 mm, and the fibers of the tufts may be either open or close-looped, crimped or uncrimped, solid or hollow. However, it is preferred that they are open-looped (i.e., uncut), and solid, so as not to catch on objects of the surface being treated This abrasive article embodiment is especially useful for cleaning or polishing uneven surfaces, such as floors known under the trade designation "Pirelli" and the like.

A third preferred abrasive article for use in the methods within the invention is a brush or carpet constructed from a plurality of microabrasive-filled fibers having first and second ends are anchored at one end to a substrate, which may be a polymeric resin or other substrate. Such an article forms a thick, carpet-like bed of microabrasive-filled fibers. In some embodiments, the microabrasive-filled fibers may be directly set in a substrate such as a channel without employing a polymeric resin. The microabrasive-filled fibers useful in this embodiment preferably have major axis length ranging from about 0.1 to about 0.5 mm, more preferably from 0.2 to 0.4 mm.

These brushes are comprised of a plurality of brush segments arranged on a hub, and are therefore sometimes referred to as rotary brushes. The brush segment generally comprises: a polymeric base; means, typically comprising a root member, for securing the polymeric base in position; and, a plurality of microabrasive-filled fibers individually imbedded in the polymeric base portion and projecting outwardly therefrom in a direction generally opposite to the root member. The polymeric base portion preferably comprises a thermoset urethane material of appropriate characteristics to resist degradation or loss of bond on extreme use conditions. In certain preferred embodiments, the root member comprises material (independent of the polymeric base portion) which is imbedded in the polymeric base portion and which is non-mechanically secured (i.e. which is adhered or bonded) thereto. In methods using these brush embodiments, the fibers typically and preferably have a major axis length ranging from about 0.1 to about 0.5 mm, while the abrasive particles preferably have average particle size ranging from about 0.1 to about 40 micrometers, more preferably ranging from about 15 to about 40 micrometers.

One preferred method of the invention comprises attaching one or more of the nonwoven abrasive articles of the invention to a conventional floor maintenance machine adapted to rotate at 175 rpm to about 2500 rpm and used to increase the gloss of acrylic and urethane floor finishes. Articles in accordance with the invention may be used in dry buffing or in spray buffing to increase the 20° and 60° gloss rating on previously dulled surfaces.

Further aspects and advantages of the invention will become apparent after reading the description which follows.

### Brief Description of the Drawing

FIG. 1 is a perspective view of a tufted abrasive article within the invention;
FIG. 2 is a transverse sectional view through the center of the article of FIG. 1;
FIG. 3 illustrates a perspective view of another abrasive article embodiment within the invention;
FIG. 4 illustrates a transverse sectional view through the center of the abrasive article of FIG. 3;
Fig. 5 is a schematic perspective view of an industrial cylinder brush arrangement having brush segments thereon;
Fig. 6 is a fragmentary side elevation view of a brush segment useful in the invention;
Fig. 7 is a cross-sectional view of the brush segment shown in Fig. 6, taken along line 7-7 thereof;
Fig. 8 is a fragmentary side elevation view of another brush segment useful in the invention;
Fig. 9 is a cross-sectional view of the brush segment shown in Fig. 8, taken along line 9-9 thereof; Fig. 9 also depicting a portion of a cylinder hub on which the brush segment is mounted and an analogous brush segment in side elevation;
Fig. 10 is a fragmentary side elevation view of another brush segment useful in the present invention;
Fig. 11 presents a cross-sectional view of the brush segment shown in Fig. 10, taken along line 11-11 thereof; Fig. 11 being a view generally analogous to Fig. 9.

### Description of Preferred Embodiments

### Use of Tufted Abrasive Articles

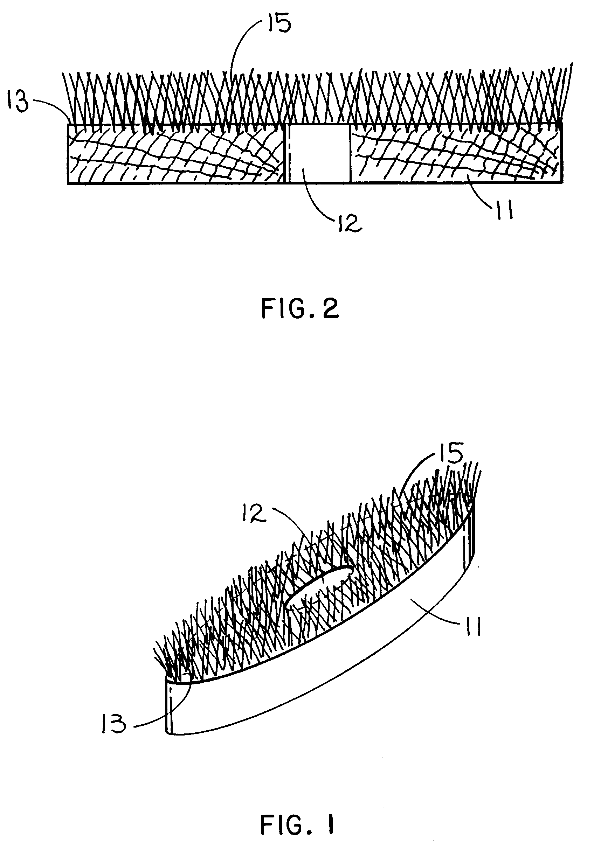

In the embodiment shown in Figs. 1 and 2 of the drawing an abrasive article is illustrated comprising a substantially circular backing 11, provided with a substantially circular central opening or recess 12, the opening or recess 12 being formed to securely engage with a cleaning machine. If the backing is made of wood other hard material, surface 13 of backing 11 has a plurality of annular drill holes placed therein to accommodate tufts of fibers. Alternatively, the tufts of fibers may be tufted into a fabric backing by carpet making methods such as known in the art. In these embodiments the back side of the fabric is preferably coated with a resin, such as a styrene-butadiene rubber latex, to seal the backing and provide added means to secure the tufts of fibers in the backing. Backing 11 may also be devoid of central hole or depression 13 if other means are used to secure the article to a rotary floor machine, such as one member of a hook and loop fastener system, or the fabric backing may be adhered to a conventional nonwoven floor pad using a suitable adhesive, the nonwoven in turn attached to the floor machine by means known in the art. For example, as taught in U.S. Pat. No. 2,958,393, floor pads are typically driven by a driving pad of the floor machine which has numerous flat-surfaced blocky resilient protuberances, the pad-engaging surfaces thereof lying substantially in a common plane.

Each tuft comprises a plurality of microabrasive-filled fibers 15, each tuft comprising a texturized yarn in which a plurality of fibers are twisted into a yarn construction. The tufted yarn can be tufted into the backing in a closed-loop or a cut loop depending on the performance requirement desired.

When using this embodiment of an abrasive article in the methods of the invention, it is desired to use microabrasive-filled fibers in the tufts which will be effective at a variety of machine speeds, but especially at low and high machine speeds and during dry and spray buffing. As used herein, the term "spray buffing" means moisture or other cleaning compositions are applied to the surface to be buffed and the area scrubbed until the friction generated between the brush and floor dries and then polishes the floor surface. It has been found that the use of tufted abrasive articles in the methods of the invention employing microabrasive-filled fibers having abrasive particles with an average particle size less than about 40 micrometers, preferably less than about 10 micrometers, exhibit less clogging and less frictional drag on surfaces being high speed burnished or polished. The brushes of this embodiment are especially effective on surfaces containing uneven areas such as non-skid surfaces, including surfaces known under the trade designation "Pirelli", which comprise uniformly spaced, raised areas separated by lower areas.

In tufted abrasive articles the microabrasive-filled fibers may comprise thermoplastic materials such as polyamide (especially nylon 6,12), polypropylene, and polyester, and thermoplastic elastomers such as thermoplastic polyester elastomers, thermoplastic urethane elastomers, and so-called "ionomers" such as those known under the trade designation "Surlyn"). Preferred thermoplastic materials are polyester, and preferred microabrasive-filled fibers for use in this aspect of the invention with high speed (i.e., 2000 rpm) propane burnishing machines are polyester fibers filled with about 30 weight percent aluminum oxide abrasive particles.

Particularly preferred fibers for use in tufted abrasive articles comprise polyethylene terephthalate as the thermoplastic portion, having fiber major axis length ranging from about 0.05 mm to about 0.1 mm, having engulfed therein about 30 weight percent (based on total weight of fiber) aluminum oxide abrasive particles having an average particle size preferably ranging from about 1 micrometer to about 5 micrometers.

Microabrasive-filled fibers for use in tufted articles of the invention may be either solid, hollow, lobed or unlobed, crimped or uncrimped. The draw ratio of the fiber making process may be as high as 10 to 1 depending on the polymeric material and the abrasive particle concentration. The fibers, if crimped, may be crimped with any mechanical crimping device, such as a stuffer-box crimper, gear crimper, and the like, air jet crimping, or by using a multi-polymeric component co-extrusion self-crimping techniques, such as co-extruding nylon/polyester side-by-side to form bicomponent fibers. Either single component or multi-component fibers may be produced using a twin-screw extruder, or other equivalent polymer processing equipment, such as a disc pack extruder. Polymer and abrasive particles are preferably fed into the extruder with independent feeders to insure uniform mixing. Although solid or hollow fibers may be used in tufted abrasive articles, it is preferred to use solid abrasive fibers.

Tufted abrasive articles for use in the present invention such as illustrated in FIGs. 1 and 2 may be produced by conventional carpet making equipment. A useful commercially available carpet making device may be obtained from Tufting Machine Division of Tuftco Corporation, Chattanooga, Tennessee. Tufting is a process whereby tufts of yarn are inserted into a backing material, called a "primary" backing, typically formed of woven or nonwoven fabric. Yarn, as is well known, is a collection or a bundle of fibers of the appropriate size in continuous or discontinuous lengths. The tufts of yarn are inserted by vertical, reciprocating needles similar to conventional sewing machines. A conventional tufting machine is like a giant sewing machine having hundreds of threaded needles held in a needle bar over a bed plate across the width of the machine. The needles receive the yarn from large beams or cones arranged in racks or a creole. Yarns of the fibers are fed to collections of needles on the needle bar to cover the backing surface with tufts to preferably provide a discontinuous tufted backing for use in floor finishing or surface maintenance applications. In the article illustrated in FIGs. 1 and 2, the tufts are uniformly discontinuously tufted into the backing, the tufts separated by a distance which typically ranges from about 5 mm to about 1 cm.

The face weight is determined by yarn spacing (or machine gage) as well as tuft length (pile height), yarn major axis length, and the like. If the pile height is too high, the microabrasive-filled fibers tend to lay over on themselves, which could reduce their abrasion efficiency. If the fiber or pile height is too low, there may be insufficient abrasive fiber available for abrading the surface being treated.

Fabric backing materials useful in the invention may be woven or nonwoven and may be formed of natural or synthetic fibers. Preferred materials for forming the primary backing include the materials that are customarily employed for conventional carpet backing including, for example, natural fibers such as cotton, and synthetic fibers, preferably those made of polyester or polypropylene. The preferred backing weight is on the order of 135 grams per square meter (g/m²).

The tufts may be inserted into the fabric backing without utilizing a conventional tufting carpet machine. One way of forming tufts in this manner is described in U.S. Pat. No. 3,943,028, the disclosure which is incorporated herein by reference for the teaching of the preparation of a tufted article without using a conventional tufting machine. Another alternative is to employ the well-known "staple set" method.

### Use of Nonwoven Microabrasive-Filled Abrasive Articles

The use of nonwoven articles in the methods of the invention may also be used for maintaining hard surfaces such as floors. The microabrasive-filled fibers, abrasive particles, degree of abrasive particle loading, draw ratio of the fiber making process, and fiber type (crimped or uncrimped, hollow or solid, multi-component or single component), are all as above described in reference to the tufted abrasive article embodiments. However, in making the nonwoven abrasive articles, an air-laid web making process, such as accomplished using a web making machine known under the trade designation "Rando-Webber" or similar process, or a spun-bonding process, can be utilized for the web formation process.

Up to about 50 weight percent of the total fiber weight may comprise polymeric fibers comprising one or more polymers which are lower melting than the polymer of the microabrasive-filled fibers. Such low melting fibers are preferably used to improve the web strength by subjecting the web to temperatures sufficient to melt the low melting fibers and bond the microabrasive-filled fibers together. The low melting fiber may also contain abrasive particles. Alternatively, the nonwoven web of microabrasive-filled fibers may be needle tacked as known in the art to improve web strength, and a combination of use of low melting fibers and needle tacking may be employed to increase the strength of the webs. The nonwoven articles useful in this aspect of the invention may be used for polishing metals, glass, plastics, marble, and the like.

As previously stated, nonwoven articles useful in this aspect of the invention may be made in accordance with the teachings of Hoover et. al, U.S. Pat. No. 2,958,593. In general a uniform, lofty, open, nonwoven three-dimensional light weight web is formed of many interlaced randomly disposed flexible durable tough microabrasive-filled organic fibers.

When employing nonwoven abrasive article embodiments, the length of the fibers which may be employed is dependent upon the limitations of the processing equipment upon which the nonwoven web is formed. The equipment known under the trade designations "Rando-Webber" and "Rando-Feeder" (marketed by the Curlator Corporation, Rochester, New York), are preferred. These machines are variously described in U.S. Pat. Nos. 2,744,294, 2,700,188, 2,451,915, and 2,703,441. With such processing equipment, fiber length ordinarily should be maintained within about 1.25 to 10 centimeters (cm), lengths of about 3 to about 5 cm being preferred. However, with other types of web forming equipment, fibers of different lengths, or combinations thereof very likely can be utilized in forming the lofty open webs herein specified.

The fiber major axis length as defined above of the microabrasive-filled fibers has an effect on the efficiency of the polishing or burnishing operation using the nonwoven abrasive articles of the invention. Preferably, the microabrasive-filled fiber major axis length ranges from about 0.025 to about 0.40 mm, more preferably from about 0.05 to about 0.10 mm. The nonwoven abrasive articles are particularly well suited for removing heel marks from floors having various finishes such as acrylic and urethane finishes, as well as from composition vinyl floors.

The average particle diameter of the abrasive particles also has an effect on the efficiency of the polishing or burnishing operation using the nonwoven abrasive articles of the invention. Preferably, the abrasive particle average diameter ranges from about 1 micrometer to about 30 micrometers, more preferably from about 3 to about 10 micrometers.

In the interest of obtaining maximum loft, openness and three-dimensionality in the web, it is sometimes preferred that all (or a substantial amount of) the microabrasive-filled fibers be crimped. However, crimping is unnecessary where fibers are employed which themselves readily interlace with one another to form and retain a highly open, lofty relationship of fibers in the formed web.

Unlike the nonwoven articles described in Hoover et. al, nonwoven articles comprised of microabrasive-filled fibers useful in the invention do not require a binder which bonds the fibers at points where they intersect and contact each other, although such binders may be used. The type of binder used depends on the fiber chemistry; binders found useful include phenolaldehyde resins, butylated urea aldehyde resins, epoxide resins, and polyester resins such as the condensation product of maleic and phthalic anhydrides and propylene glycol. If the thermoplastic component of the microabrasive-filled fiber is polyester, and if a phenolaldehyde resin is used as binder, it may be desirous to treat the formed web with peroxides and/or ultraviolet radiation prior to application of the binder, to enhance adhesion of the phenolic resin to the polyester portion of the fibers. Such techniques are described in assignee's European patent application EP 0 492 868 A1, published July 1, 1992, (McCoy et al.).

Contrary to the statement in U.S. Pat. No. 3,537,121 (McAvoy) at column 1, lines 66-70, the nonwoven articles of the present invention exhibit significantly less drag and clogging characteristics than nonwoven abrasive articles comprised of fibers having abrasive particles with average diameter greater than 30 micrometers. It should be noted that, in general, the finer the fibers (i.e. smaller major axis length), the less open the nonwoven article and the less its tendency to impart swirl marks, but the greater its tendency to drag. It should be apparent that the nonwoven abrasive articles useful in the methods of the invention may be used on flat or uneven surfaces, but are preferably used on flat surfaces, the tufted abrasive articles of the invention being especially useful on uneven surfaces, as previously noted.

### Useful Brush Embodiments

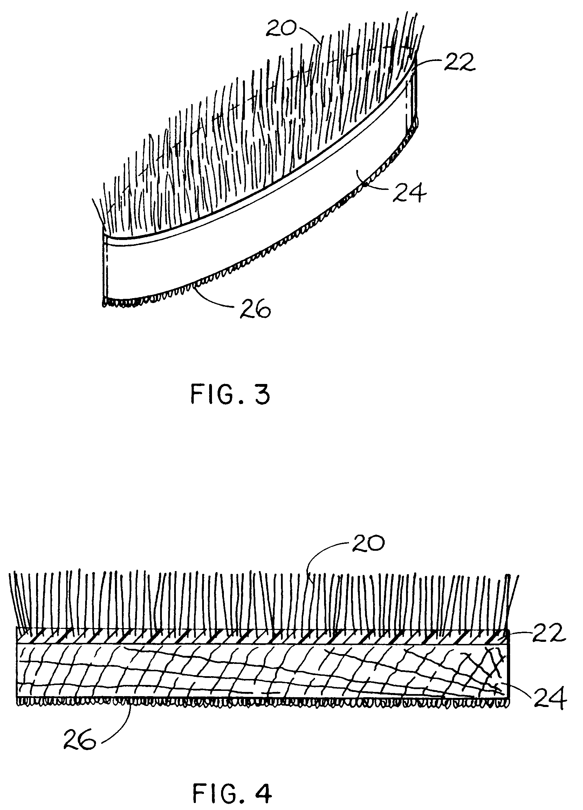

Particularly preferred fibers for use in "brush" abrasive articles of the type illustrated in Figs. 3 and 4 are polyamide, particularly nylon 6,12, having fiber major axis length ranging from about 0.1 mm to about 0.5 mm, having engulfed therein about 30 weight percent (based on total weight of fiber) silicon carbide abrasive particles having an average particle size preferably ranging from about 0.1 micrometer to about 60 micrometers, more preferably from about 15 to about 45 micrometers. The length of microabrasive fibers useful in constructions illustrated in FIGs. 3 and 4 may have about the same range as the tufted articles illustrated in FIGs. 1 and 2 (about 1 to about 5 cm), although longer or shorter fibers may be employed.

Referring to Figs. 3 and 4, Fig. 3 illustrates a perspective view of a brush embodiment useful in the methods of the invention, the brush comprising a plurality of microabrasive-filled fibers 20 adhered at one end to a polymer resin 22, which is in turn adhered to a backing or substrate 24. The microabrasive-filled fibers 20 are as described above in relation to the tufted abrasive articles and the nonwoven abrasive articles. However, rather than the fibers being formed into an open, lofty three-dimensional web, or a yarn which is tufted into a backing, a plurality of individual fibers are adhered to a polymeric resin 22. Backing or substrate 24 may have on its side surface 26 which faces away from the microabrasive-filled fibers one half of a hook-and-loop-type fastener so that the article may be attached to a conventional floor maintenance machine. Backing 24 may itself serve as one half of such a fastener. It should also be understood that backing 24 and polymeric resin 22 could be one material, as in Example 1' below.

Alternatively, brush embodiments may be made with a conventional continuous metal strip brush making machine such as that known under the trade designation "Model Y", available from the Carlson Company, Geneva, IL. Such a machine may be used to prepare brushes having fiber lengths from 17.8 cm and less. Brushes made by this apparatus and like apparatus are commonly referred to as "channel" brushes. Machines of this type essentially comprises a mechanism whereby along metal strip up to 0.16 cm thick and up to 3.2 cm wide is bent to form a crease and the crease traversed perpendicularly by a plurality of fibers. A wire is placed by the machine down the center of the crease in the metal strip over the fibers (essentially bisecting the fibers). The machine essentially crimps the metal strip, anchoring the fibers therein in a U-shaped channel.

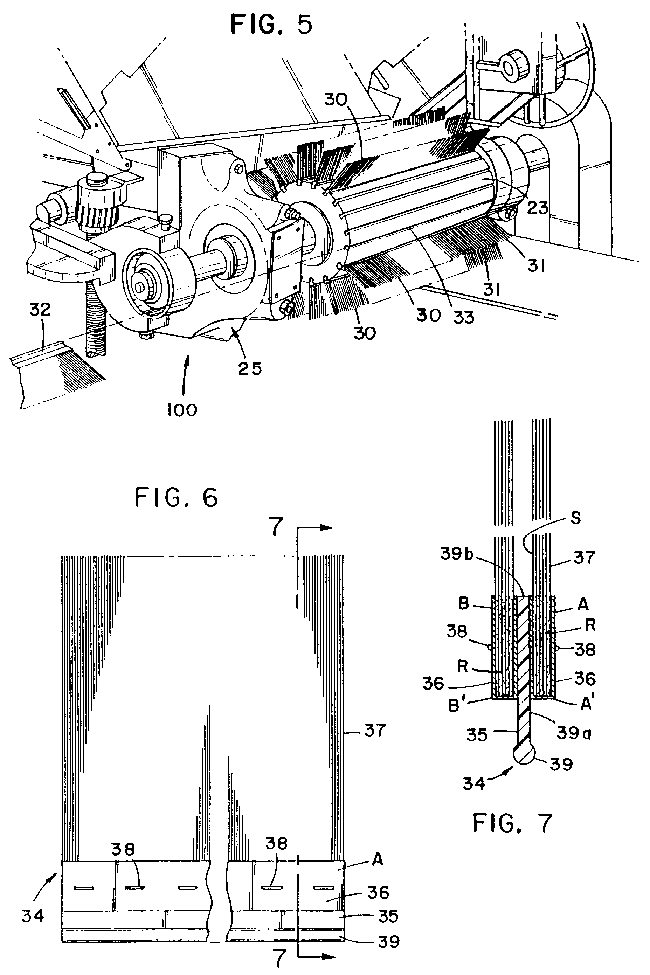

The reference numeral 100, Fig. 5, generally illustrates an industrial cylindrical brush finishing device (rotary brush) modified by inclusion of improved brush segments therein. Specifically, device 100 comprises a horizontally mounted cylinder hub 23, mounted in mechanical device 100 such that hub 23 can be selectively rotated at preferred speed, typically about 2000-4400 surface feet per minute (645-1340 meters per min.). Arrangement 100 generally not only includes a drive mechanism 25 for hub 23, but also adjustive means (not detailed) for selected positioning of the hub 23 relative to a path of movement of articles to be treated upon passage through the arrangement 100. The hub 23 may be generally as described in U.S. Patent No. 5,083,840.

Device 100 further includes a plurality of brush segments 30 mounted thereon. Each brush segment 30 extends longitudinally along hub 23, with microabrasive-filled fibers 31 projecting outwardly therefrom. As hub 23 is rotated, fibers 31 are spun into contact with an article, to finish same. In a long trim wheel, such as that depicted, a considerable "flapping" action occurs, as the fibers (and to some extent other portions of the brush segments) rock in relation to the hub 23 and brush against a substrate. Typically, a "rock" or "flap," (i.e. more than mere bending of the fibers) on the order of at least about 5 degrees, typically about 10 to 20 degrees, will occur.

In Fig. 5, a brush segment 32 is shown in orientation for mounting, i.e. sliding into a slot 33 on hub 23.

Brush segments useful in the present invention are depicted in Figs. 6-11. In particular, the reference numeral 34, Fig. 6, depicts a conventional long trim brush segment, such as available under the trade name "Brushlon", from Minnesota Mining and Manufacturing Company, Saint Paul, Minnesota 55144. Segment 34 is of a type utilizable with a conventional cylinder hub, such as an "RX Brand" aluminum hub, also available under the trade name "Brushlon" or "Brushlon/RX", from Minnesota Mining and Manufacturing Co., St. Paul., MN ("3M").

Segment 34 generally comprises a root 35, scrim wrapped section (fiber pack) 36, and fibers 37. In general, the root 35 is configured for engagement with slots, on a slotted hub. Scrim wrapped section 36 secures ends of fibers 37 in position. Scrim wrapped section 36 is mechanically mounted on root 35, by staples 38 which extend completely through the segment 34. For a typical long trim brush segment (before wear during use), fibers 37 will have a length of extension, out of scrim wrapped section 36, of at least about 2 inches (at least about 5 cm), and typically at least about 3-12 inches (i.e. about 7.5-30.5 cm). Referring to Fig. 7, root 35 includes an expanded base portion (bottom bead or ball portion) 39 and a neck portion 39a. As will be understood by reference to Fig. 7, brush segment 34 generally has two packs or sections of scrim 36 (with fibers 37 mounted therein) one on each side of neck portion 39a. These are indicated generally at reference letters "A" and "B", respectively.

Each of sections A and B comprises a fold of scrim material A' and B', respectively, with ends of fibers 37 projecting there into. The fibers 37 are held in place by cores of hot melt resin "R" received within scrim material A' and B'. A conventional hot melt resin utilized for this purpose is polyamide thermoplastic.

Brush segments such as those illustrated in Figs. 6 and 7 have been utilized in a variety of environments. However, they may be subject to loss of fibers therefrom, especially when used in wet or caustic environments, or with organic solvent solutions. Also, the staples 38 and scrim material A' and B' occupy width which is wasted, i.e., not occupied by the presence of fibers. Further, end 39b of root 35, Fig. 7, generates a space "S" which is wasted in a similar manner, because the sections of fibers (A and B) must be anchored on opposite sides of neck 39a. That is, due to space S, brush segment 34 is a low density brush.

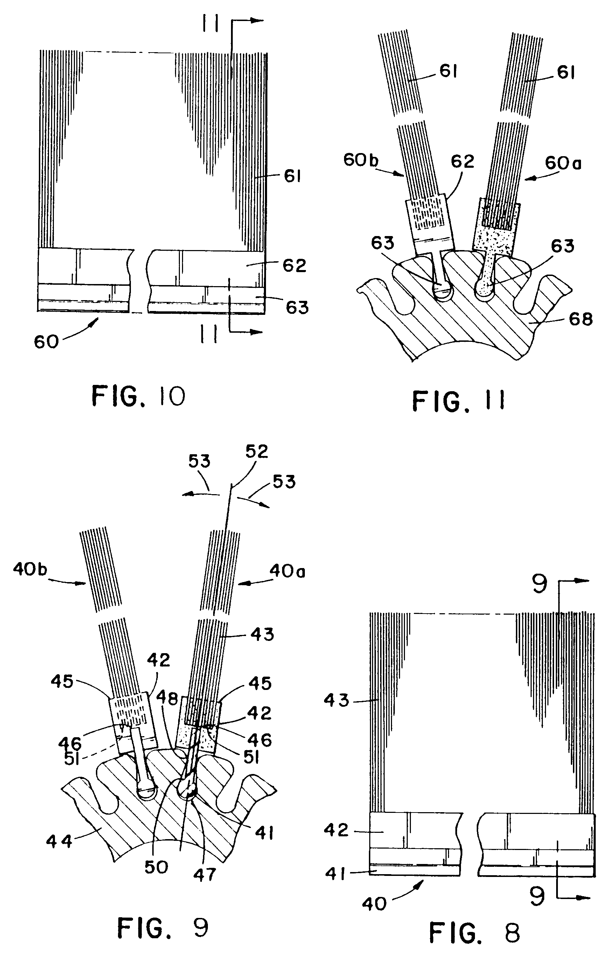

In reference to Fig. 8, an alternate brush segment for use in the invention is generally indicated at 40. Brush segment 40 may be utilized as one of brush segments 30, Fig. 5. Brush segment 40 generally includes a root member 41, a polymer block or base 42, and fibers 43. Fibers 43 are individually anchored within polymer base 42, i.e. an end of each microabrasive-filled fiber 43 is imbedded in the polymer of base 42. The arrangement of Fig. 8 contains no scrim; and, no mechanical connection (staples) for the various parts is needed. By the term "mechanical connection" and variants thereof in this context it is meant that no mechanical devices such as staples or rivets are necessary to ensure secure attachment of the root member to the polymer base; rather a bond or adhesion (non-mechanical connection) between the two is provided.

Herein, the longitudinal extension of the polymer block or base 42 (left to right in Fig. 8) will be referred to as the "width" or "face width" of the brush segment 40. The extension from the surface of the hub to the outer tip of the fibers, Fig. 8, will be referred to as the "length" of the brush segment. The dimension through the polymer block (left to right in Fig. 8) will be referred to as the thickness.

In Fig. 9, a fragmentary view of a hub 44 is shown, with segments 40 mounted therein. Two adjacent segments 40a and 40b are depicted. To facilitate understanding, one segment 40a is depicted as a cross-section of Fig. 9, the other (40b) is not.

Referring to Fig. 9, microabrasive-filled fibers 43 are substantially evenly distributed to project outwardly from upper (outer) surface 45 of base 42. There is no central gap in arrangement of Fig. 9. That is, fibers 43 are distributed to occupy the space immediately "above" or "over" end 46 of root member 41, as shown.

Polymer base 42 is not mounted on root member 41 by mechanical means such as staples. Rather, polymer base 42 comprises a polymer which is cured (molded) on root member 41, to be secured (adhered or bonded) thereto. For preferred embodiments, the resin is the sole means of attachment of the base 42 to the root member 41.

Root member 41 includes an expanded base (bead or ball) 47 and a neck portion 48. Base 47 and neck portion 48 are sized and configured for engagement within longitudinal slot 50 of an industrial brush cylinder hub 44. In addition, neck 48 should extend up into polymer block 42 sufficiently, for secure engagement. Generally, an extension of neck 48 of at least about 0.19 inch (about 0.5 cm) and preferably about 0.25-0.5 inch (0.6-1.3 cm) into polymer block 42 will be sufficient.

Preferably, arrangements 40a and 40b, Fig. 9, are constructed such that neck portion 48 terminates, as indicated at 46, beneath bottom ends 51 of microabrasive-filled fibers 43.

Hereinabove, reference has been made to an amount of "rocking" or flapping movement in the brush segments, during use. In Fig. 9, this movement would be total angular bending or flapping (deflection) about central axis 52 in the directions of arrows 53 from one extreme to another.

While a variety of materials may be utilized in brush constructions useful in the invention, particular preferred materials lead to advantageous properties of the construction, especially with respect to: strength of the root member to resist breaking in use (for example, due to the stresses of the flapping); and, resistance to microabrasive-filled fiber fallout, or loss, (especially when used under humid, wet or caustic conditions; or when heated; or when used with a solvent solution).

For typical long trim applications, the microabrasive-filled fibers should be sufficiently long to extend outwardly from the resin or polymer base 42 a distance of at least 2 inches (about 5 cm), and typically at least about 3-12 inches (about 7.5-30.5 cm). The fibers should be imbedded within base 42 a distance sufficient for secure anchoring, generally at least about 0.25 inch (about 0.6 cm) and typically about 0.3-0.9 inch (not including wicking), i.e. about 0.8-2.3 cm. A preferred arrangement is one wherein the fibers are sufficiently long to provide a brush segment length to thickness ratio of at least 3 and preferably at least within the range 5-19.

It is important that the root member comprise materials which can withstand the stresses of use due to heat buildup during rotation, pressures associated with finishing operations and the extra stresses generated by the flapping action of the brush member in operation. It has generally been found that polymeric materials having the following properties will be preferred: hardness- Shore A (BSI Method 365A, Part 3) at least 94, preferably at least 97 and most preferably off scale, Shore D (ASTM:E 448-82) at least 50, preferably at least 52 and most preferably 55-72; % elongation at break, at least 300%, preferably at least 325%, and most preferably 350-450%; tensile stress at break preferably at least 5200 psi (pounds per square inch) (i.e about 36.5 MPa (MegaPascals)) more preferably 5700 psi (about 39 MPa) and most preferably about 5900 to 6600 psi (about 41-45.5 MPa); flexural modulus at -40°F 100,000-350,000 psi (690-2400 MPa), at 93°F 30,000-85,000 psi (200-590 MPa) and at 212°F 16,000-30,000 psi (110-210 MPa). By "offscale" with respect to hardness (Shore A) it is meant that the material is too hard to get an onscale measurement by the test.

It is presently foreseen that thermoset urethane materials can be utilized as the root members. Other materials such as polymer blends of copolyester/polyacrylate/polyester may be used. Preferred materials, commercially available, are those known under the trade designations "Hytrel 5556", "Hytrel 6256" and "Hytrel 7246", available from DuPont, Wilmington, Delaware 19898, which can be readily extruded in a strip form of appropriate shape and dimension.

Preferred dimensions for the root member, when used in association with an RX hub or the like, are: total height (ball portion to tip of neck portion) at least about .80 inch (2 cm) (typically 0.87-1.0 inch or 2.2-2.5 cm); length of neck portion, at least about 0.625 inch or 1.6 cm (typically 0.75-0.87 inch or 1.9-2.2 cm); thickness of neck portion about 0.095-1.05 inch (0.15-0.2 cm); diameter of lower expanded ball portion 47 (bead), about 0.23 to 0.25 inch (0.56-0.64 cm).

The base portion 42 preferably comprises a polymeric material which can be readily processed to include both the microabrasive-filled fibers and the root member secured therein with mechanical connections; and, which will withstand the conditions of use sufficiently to provide secure engagement with the root member and fiber material throughout use. Material which can (optionally) be utilized under wet and/or caustic finishing conditions will be preferred.

Preferred materials for utilization of the polymeric base are cured (thermoset) urethanes. The resin materials from which the urethane is formed should be such as to provide a cured urethane having the following properties: hardness: at least 90 Shore A, preferably at least 95, and most preferably 97 to offscale; at least 50 Shore D, preferably at least 52 and most preferably 54 to 60; elongation: at 100% elongation at least 1100 psi (about 7.6 MPa), more preferably 1500-2100 psi (10.4-14.5 MPa), and most preferably 1700-1900 psi (about 11.7-13.1 MPa); at 300% elongation: at least 2200 psi (about 15.2 MPa) preferably 3200 to 5000 psi (about 22.1-34.6 MPa) and most preferably 4200-4800 psi (about 29-33.2 MPa); tensile stress at break: preferably at least 3900 psi (about 27 MPa), preferably 4300 to 5600 psi (about 29.7-38.7 MPa) and most preferably 4700 to 5300 psi (about 32.5-36.5 MPa). If the polymer base is formed from a material as defined, generally the brush will: remain intact at high operation rotative speeds; remain intact under wet or caustic conditions; and, will resist deterioration under heat build-up in use.

The uncured resin mixture from which the polymeric base is formed should preferably provide a viscosity at 72°F (22°C), of 10,000-34,000 centipoise, for ease of handling.

Commercially available resin materials may be utilized to form the cured urethane of the polymer base. Preferred materials include those known under the trade designations "Adiprene L-767" (a polyester-toluene diisocyanate), cured with "Caytur 21" (a complex of methylene dianiline, i.e. MDA, and sodium chloride, dispersed in dioctyl phthalate); or "Adiprene L-315" (a polyester-toluene diisocyanate) cured with "Caytur 21"; available from UniRoyal Chemical Co., Middlebury, Connecticut 06749. Such materials are preferred since they provide the physical strengths and properties toward the preferred ends of the ranges stated above; and, can be processed readily with an avoidance of substantial porosity. (In general, porosity in the resin leads to a weak system, more likely to break or lose its integrity during use.) Other usable commercially available urethane resin systems include those known under the trade designations: "Vibrathane" B-600, B-601, B-615, B-621 or B-627 (polyether-toluene diisocyanates, i.e. polyether-TDI's), cured with 4,4'-methylene-bis(2-chloroaniline) (i.e. MOCA); "Vibrathane" 8080 or 8050 (polyether - TDI's), cured with MOCA; "Vibrathane" B-625, B-635 or B-670 (i.e. polyether-diphenylmethane diisocyanates or polyether-MDI's), cured with "Vibracure" 3095; and "Vibrathane" 6012 or 8022 (polyether - MDI's), cured with either 1,4-butanediol or "Vibracure" 3095; the "Vibrathane" and "Vibracure" products being available from Uniroyal Chemical Co., Inc. Air Products and Chemicals, Inc. (of Allentown, PA 18105) urethanes "1080" or "1090" (polyether - TDI's), cured with MOCA; or Miles, Inc. (of Pittsburgh, PA 15205) "410", "2680" or "2690" (polyester - TDI's), cured with MOCA could also be used.

In general, resins which exhibit a heat blocked cure are preferred over those which exhibit an exothermic room temperature cure. Although either may be utilized, resins which exhibit exothermic room temperature cure will generally require small batch mixing due to limited pot life or the need for in-line meter-mix systems. Resin systems which provide for heat blocked cures, can be mixed and will remain generally latent until heated during processing to the appropriate cure temperature. The two preferred commercially available resin systems described above (the Adiprene systems) exhibit the desirable properties of heat blocked cure.

Preferred dimensions for the polymer base (42) are: sufficient depth to provide secure anchoring of both the root member and the microabrasive-filled fibers (generally at least 0.4 inch (1 cm), typically 0.6-1.0 inch (1.5-2.5 cm); and, a thickness no greater than would allow 2 segments with such polymer bases 42, Fig. 8, to be mounted adjacent to one another in adjacent slots on a conventional slotted hub. Generally a thickness of at least 0.5 inch (1.25 cm), typically at least about 0.625 inch (1.58 cm) will be appropriate.

A variety of methods of manufacture may be utilized for brush segments as described in Figs. 8 and 9. Conventional molding techniques can be utilized. In general, an appropriate root member (already extruded and cured) is placed in a mold of appropriate configuration. The resin is poured in, around a neck portion of the root member to which the polymeric base is to be secured. The fibers are dropped into the polymeric block and are held in place as the polymeric block is cured. The preferred microabrasive-filled fiber density is about 4.8-8.0 grams of bristles per inch brush segment face width per inch fiber length, or about 0.75 to 1.25 grams of fibers per cm brush segment face width per cm fiber length.

In some instances it may be important to pretreat the surface of the root member, prior to immersion in the resin of the polymer base, in order to ensure a good bond between the two. If commercially available Hytrel is utilized as the root member, for example, an outer skin of the extruded root member (in the neck portion) should be removed by sanding or otherwise roughening the outer surface of the neck portion to be immersed in the polymer base. In general, a roughening of the surface of the root member neck portion facilitates secure engagement (bonding) between the root member and the polymer base by increasing surface area, so that the cured product will resist delamination.

A variety of adjuvants may be utilized in polymer systems for both or either of the polymer base or the root member. Such adjuvants include, for example, conventional fillers, dyes, and/or antistatic agents.

In some applications, the base portion and root member may be molded, simultaneously, from a single resin system. Such a construction is illustrated in Figs. 10 and 11. Referring first to Fig. 10, brush segment 60 comprises microabrasive-filled fibers 61, polymer base 62, and root member 63. Referring to the cross section illustrated in Fig. 11, it will be understood that the polymer base 62 and root member 63 are of a unitary construction, molded from a single resin system. In Fig. 11, reference numeral 60a refers to a cross-section of arrangement 60, Fig. 10, and numeral 60b refers to a side elevation view. Arrangements 60a and 60b are depicted, in Fig. 11, mounted in hub 68.

It is foreseen that such systems may be readily constructed provided the resin system utilized provides for a cured material of appropriate strength to meet the minimum needs of the root member. That is, the root member is subjected to substantial lateral forces of stress during use, due to the previously described flapping action of the long trim brush segment. For the arrangement shown in Figs. 8 and 9, it was not necessary for the resin material of the polymer base to be quite as strong as the material for the root member. Such will not be the case, however, for the arrangement of Figs. 10 and 11.

In general, it is foreseen that the resin system from which the polymer base 62 and root member 63 of Figs. 10 and 11 is formed; should provide a cured material having the properties described above with respect to the arrangement of Figs. 8 and 9, for the root member. The preferred dimensions and other features described above for the embodiment of Figs. 8 and 9 will be generally applicable for the arrangement of Figs. 10 and 11.

Fibers particularly useful in the invention for use in brush articles illustrated in Figs. 5-11 are polyamide, particularly nylon 6, 12, having fiber major axis length ranging from about 0.1 mm to about 0.5 mm, having engulfed therein about 30 weight percent (based on total weight of fiber) silicon carbide abrasive particles having an average particle size preferably ranging from about 0.1 micrometer to about 40 micrometers, more preferably ranging from about 15 to about 40 micrometers. In terms of water resistance, nylon 12 is more resistant than nylon 6,12, which in turn is more resistant than nylon 6,6. Thus nylon 6,6 may be used for dry buffing, but is not preferred for wet buffing.

Bicomponent fibers may be used in the articles of this invention if the abrasive particles are in the outer portion or outer component of the bicomponent fibers.

In brush abrasive articles useful in the invention, the tip of the microabrasive-filled fibers are especially important in short trim wheel and floor brushes, affording good polishing and abrading characteristics of floors, whereas long trim brushes tend to rely more on the sides of the fibers, especially in wood defuzzing and cleaning of pewter items, such as intricate jewelry.

Solid and hollow fibers may be used, as well as lobed and nonlobed fibers. As stated previously, initially flagged and initially unflagged microabrasive-filled fibers may be beneficial, depending on the workpiece. Hollow fibers may have their ends slit multiple times, or the tips may flattened, or solid fiber tips may be slit or tapered. All of these fiber modifications are generally referred to as "flagging", and may be achieved by conventional means known in the fiber art.

### Abrasive Particles

Microabrasive particles useful in the invention are preferably those able to be dispersed throughout, adhered within, and engulfed by the thermoplastic polymer used to form the fiber. It should be apparent that some abrasive particles may not be completely engulfed, i.e., they may protrude from the polymer surface. For those particles which are not one hundred percent engulfed by polymer, it may be more proper to characterize such abrasive particles as being anchored in the polymeric material.

Abrasive particles useful in the abrasive fibers of the present invention may be individual abrasive grains or agglomerates of individual abrasive grains provided the average size of the agglomerates or individual abrasive grains is greater than about 0.1 micrometer and less than about 60 micrometers. Suitable agglomerated abrasive particles are described in U.S. Pat. Nos. 4,652,275 and 4,799,939.

The microabrasive particles may be of any known abrasive material commonly used in the abrasives art. Preferably, the microabrasive particles have a hardness greater than or equal to about 7 Mohs, most preferably greater than about 9 Mohs. Examples of suitable abrasive particles include individual silicon carbide abrasive particles (including refractory coated silicon carbide abrasive particles such as disclosed in U.S. Pat. No. 4,505,720), fused aluminum oxide, heat treated fused aluminum oxide, alumina zirconia (including fused alumina zirconia such as disclosed in U.S. Pat. No. 3,781,172; 3,891,408; and 3,893,826, commercially available from the Norton Company of Worcester, Mass, under the trade designation "NorZon", cubic boron nitride, garnet, pumice, sand, emery, mica, quartz, diamond, boron carbide, fused alumina, sintered alumina, alpha alumina-based ceramic material available from Minnesota Mining and Manufacturing Company ("3M"), St. Paul, MN, under the trade designation "Cubitron" (such as those disclosed in U.S. Pat. Nos. 4,314,827; 4,518,397; 4,574,003; 4,744,802; 4,770,671; and 4,881,951), and combinations thereof

The microabrasive particles are preferably present at a weight percent ranging from about 0.1 to about 40 weight percent, more preferably from about 25 to about 35 weight percent. The preferred abrasive particle average particle size depends somewhat on the type of article the fibers are used in. The preferred average particle sizes are referred to above in the sections discussing the individual articles useful in the invention.

In order to achieve higher abrasive particle loadings without sacrificing fiber tensile strength it may be preferred, depending on the thermoplastic or thermoplastic elastomer used, to coat the abrasive particles with a coupling agent prior to introduction of the particles into the polymer melt. Alternatively, the coupling agent may be added to the polymer melt in the form of a pellet containing from about 10 to about 30 weight percent of coupling agent, and from about 70 to about 90 weight percent of a thermoplastic. In this latter method, the coupling agent-containing pellets are added to the polymer melt in an extruder "upstream" of the point or the abrasive particles are added. The addition rate is calculated to provide a weight percent coupling agent per total weight of microabrasive-filled fiber ranging from 0.01 to about 2.0, more preferably ranging from about 0.02 to about 0.3.

Coupling agents found useful and thus preferred for use in this invention are the neopentyl(diallyl)oxy titanates, such as neopentyl(diallyl)oxy,tri(m-aminophenyl) titanate and neopentyl(diallyl)oxy,tri(dioctylphosphato) titanate. The tri(m-aminophenyl) and tri(dioctylphosphato) versions are available in pellet form (20 weight percent in thermoplastic polymer) under the trade designations "LICA 97/E" and LICA 12/E", respectively, from Kenrich Petrochemicals, Inc., Bayonne, New Jersey.

The surface of the abrasive particles (or a portion of the surface, or a portion of the particles but their whole surface) may be treated with coupling agents to enhance adhesion to and dispersibility in the molten thermoplastic material.

The microabrasive particles are not required to be uniformly dispersed in the thermoplastic material which forms the fibers, but a uniform dispersion may provide more consistent abrasion and polishing characteristics and more consistent gloss.

### Optional Fiber Additives

The microabrasive-filled fibers useful in the articles of the invention may contain fillers, lubricants, colorants and/or pigments, grinding aids, ultraviolet light stabilizers, and the like in levels typically used in the abrasives art.

If the thermoplastic material used to produce the microabrasive-filled fibers is a polyolefin or mixture of same, the most common method of coloring polyolefins is to add pigments to the polymer melt before extrusion. Preferred pigments include titanium dioxide (white), cadmium salts (reds, oranges, yellows), iron oxide (brown), and a variety of organic pigments. Polypropylene-based microabrasive-filled fibers having dispersed therein poly(vinylpyrridine), or vinylpyrridine units grafted onto the polypropylene chain, may be acid-dyed. Nickel-modified polyolefins contain a small amount of an organic nickel compound which is capable of chelating and forming a metal-dye complex with certain mordant disperse dyes, as discussed by A.F. Turbak, Text. Res. J., Vol. 37, page 350 (1967). Each of the modified types is more expensive than the pigmented polypropylene fiber, and thus the pigmented versions are generally preferred.

Polyolefin-based microabrasive-filled fibers preferably have dispersed therein an ultraviolet light stabilizer, such as carbon black. Also, the previously mentioned pigments may absorb in the UV region.

One especially useful class of lubricants are alkali metal stearates, alkali metal oleates, and the like, herein after referred to as "fatty acid lubricants." These particular lubricants are especially effective in spray buffing applications, where, as previously described, moisture or buffing compound is applied with a spray device on the area to be polished or abraded until the friction generated between the brush and the surface dries and then polishes the floor or surface.

Fatty acid lubricants, if employed, are added to the polymer melt which forms the fibers, as more particularly described in "Fiber Making" section below. Typically and preferably the fatty acid lubricants are added at 0 to about 10 weight percent of the total weight of polymer, abrasive particles, and filler. The weight percent lubricant added ultimately depends on the end usage of the article.

### Machines to Which the Articles Useful in the Invention May Be Attached

It is of course an object of the present invention to use articles which, when attached to a typical floor maintenance machine or similar machine, achieve an increase in gloss on the surface, or when used to remove undesirable materials, effectively perform that function. "Gloss" pertains to the surface shininess or luster. When light shines on a surface, substantial incident light will be refracted or scattered by the scratches on the surface. If the surface is relatively clean and free of scratches, substantial incident light will be reflected resulting in high gloss surface.

Abrasive articles useful in the invention may be used either dry or in a spray mode. Spray buffing is most frequently used with nonwoven abrasive articles in accordance with the invention, although it may also be used with tufted and brush embodiments. Polishing in the presence of a liquid may result in a finer finish, i.e. a higher gloss surface. The liquid can be water, an organic lubricant, a detergent, a coolant or combinations thereof The liquid may further contain additives to enhance polishing. Typical and preferred liquids for spray buffing comprise a mixture of water, a surfactant, and an organic solvent for black mark removal. A spray buffing liquid may also contain an acrylic or urethane polymer similar to those employed in floor finishes, water, detergents, waxes, and the like. Spray buff liquids are readily available commercially, and include those known under the trade designations "3M Brand Spray Buff Cleaner and Polish" from Minnesota Mining & Manufacturing Company, St. Paul, MN.

During polishing or abrading of a surface, the abrasive article moves relative to the surface and is forced downward onto the surface preferably with a force ranging from about 35 to about 350 kilograms per square meter, more preferably between about 70 and about 175 kilograms per square mm. If too high of a down force is used, then the abrasive article may not refine scratches in the surface being buffed, and in some instances may actually increase scratch depth. Also, the abrasive article may wear excessively if the down force is too high, and the current draw on electric buffing machines may increase significantly which may lead to blown fuses and/or circuits. If too low of a down force is used, the abrasive article may not effectively refine scratches and remove marks such as heel marks from the surface, and may not generate the desired level of gloss.

As previously stated, the surface being buffed, the abrasive article, or both will move relative the other during the polishing, buffing, or burnishing operation. This movement may be rotary motion, random motion, or linear motion. Rotary motion can be generated by attaching an abrasive article within the invention in the form of an abrasive disc to a rotary tool. For hand-held tools the tool operating rpm may range up to 4,000 rpm, while typical floor maintenance machines operate anywhere from about 150 to about 3000 rpm. A random orbital motion can be generated by a random orbital tool, and linear motion can be generated by a continuous abrasive belt article formed from one of the three abrasive article embodiments within the invention.

The relative movement between the surface being buffed and the abrasive article may depend upon the dimensions of the surface. If the surface is relatively large, it may be preferred to move the abrasive during polishing or buffing while the surface is stationary, such as when a floor is being polished or burnished. Floor maintenance machines such as those available from Advance Company, Minneapolis, MN, are preferred. These machines typically having a head to which the abrasive article is attached having a diameter of about 33 to 67 cm, more typically about 51 cm.

In order that the articles and methods of the present invention will be better understood, the following test methods and examples are provided in which all parts and percentages are by weight unless otherwise specified.

### Fiber Making

The microabrasive-filled fibers used in the following examples were produced by the following procedure.

A suitable thermoplastic material (e.g., polyamide, polyester, or the like, according to the specific example) was mixed with abrasive particles such as alumina, silicon carbide, garnet, and the like in a 30-mm barrel diameter co-rotating twin screw extruder commercially available from Werner & Pfleiderer Corporation, Ramsey, NJ. In order to minimize wear on the extruder parts, the abrasive particles were added only after the thermoplastic material was melted, thereby providing a fluid interface. Optional fillers, such as grinding aids, lubricants, and the like, were mixed into the melt as desired. The extruder barrel temperatures depended of course on the polymer used for the fibers. For nylon 6,12, typical barrel temperatures used might be 400-500°F.

The mixture of abrasive particles, molten polymer, and optional fillers was pressurized by a gear pump commercially available from Zenith Pumps Division, Parker Hannifin Corporation, Sanford, CA and spun through a spinneret having thirty 0.75-mm diameter circular orifices. The resulting fiber major axis lengths (diameters) were typically about one half the diameter of the orifice diameter, although this was not required. The fibers were cooled in a water bath. The resulting fibers were optionally stretched (or drawn) as stated in the examples to increase dimensional stability and/or tensile properties. The fibers were then wound onto a hank winder of about 760 mm o.d. When the appropriate number of wraps were collected, the circular bundle was cut and wrapped to produce a finished hank of about 38 mm diameter and 2.3 meters in length. The finished hank was then cut into appropriate lengths using a guillotine cutter commercially available as Model 52 from Carlson Tool and Machine Company, Geneva, IL.

### General Segmented Brush Making Method

Brushes such as those illustrated in Figs. 6 and 7 may be made using the above-described fibers. Abrasive fibers are generally cut to the desired trim length, typically from 100- to 260-mm lengths, and one end of each fiber is aligned uniformly in a substantially linear tray lined with a fabric scrim. The fibers are then clamped with a toggle clamp assembly to prevent subsequent movement, and a hot-melt adhesive such as the polyamide adhesive commercially available as "HL6154X" from H.B. Fuller Company, St. Paul, MN is melted and dispensed into the scrim-lined tray such that a free end of fiber array is completely encapsulated. The hot-melt adhesive may be dispensed with any of a variety of dispensing devices. One preferred device is a Model 2302 dispenser available from Nordson Corporation, Norcross, GA. Upon cooling, this sub-assembly is removed from the tray and clamping assembly. A final brush segment suitable for use in an extruded aluminum hub (such as those hubs having a plurality of slots, known under the trade designation "RX", available from Minnesota Mining and Manufacturing Company, St. Paul, MN) is completed by mechanically fastening one of the subassemblies onto each side of an elastomeric root member shaped to securely engage the slots and receptacles of the hub. Upon insertion of such an assembly into each of the hub slots, a finished brush results.

### Alternate Brush Making Methods

Brushes of the type illustrated in FIGs. 3 and 4 may be produced by any one of a variety of methods. The flocking methods (or variations thereof) described in U.S. Pat. Nos. 3,436,245 and 3,527,001 may be used to advantage. One method, for example when layer 22 comprises a polymeric layer, and layer 24 is a fabric backing, comprises depositing a curable layer of adhesive onto a fabric backing, either in a pattern or as a complete layer, to form an adhesive/backing composite; depositing microabrasive-filled fibers of the desired size and shape uniformly onto the adhesive and any exposed backing fabric to form a fiber/adhesive/backing composite; subjecting the latter composite to means to induce the fibers to stand on end essentially perpendicular to the plane of the backing, such means for example being an electrostatic field or mechanical beater bar rotating underneath the backing, thus forming a first brush precursor; exposing the first brush precursor to conditions sufficient to cure or solidify the adhesive to form a second brush precursor; brushing and/or applying suction to the fiber-containing side of the second brush precursor to remove any unbonded fibers therefrom; and cutting the second brush precursor into the required shape.

The adhesive may be comprised of any coatable curable material that has sufficient flexibility in the cured state to avoid inordinately stiffening the fabric or other backing material, an therefore the final article. Examples of suitable curable flexible materials include, but are not limited to polyurethane resins, polyurea resins, styrene-butadiene copolymers, modified epoxy resins, and polyisoprene and polychloroprene rubbers. The preferred materials for use as the adhesive are polyurethanes.

The method of applying the curable layer of flexible resin may employ any one of a number of methods. If a pattern of fibers on the backing is to be produced, preferred methods include screen printing, gravure printing, pad printing, and the like, with gravure printing being the presently preferred method. In the event that patterns of fibers are not desired (i.e., the entire backing is to be covered with upstanding fibers), any one of the coating techniques familiar to those skilled in the art may be employed, such as knife coating, die coating, spray coating, roll coating, and the like. The preferred methods in this instance are knife coating and roll coating, with knife coating being particularly preferred.

The backing material 24 in FIGs. 3 and 4 may be none flexible, such as wood as depicted in FIG. 4, metal and the like non flexible materials, or flexible material such as flexible fabrics, polymeric films, and the like. If a flexible backing is desired, preferred are polymeric sheets or film comprised of polyurethane, polyester, or polyamide, or it may be of a suitable fabric such as industrial belting material, canvas, polyester/cotton blend fabrics, or nylon fabrics. The fabrics may be woven or nonwoven. For efficacy in the final brush products, especially those articles useful in the invention for polishing floors, a nylon loop cloth is the preferred backing, since it provides for its use with mechanical "hook and loop" attachment systems. Other preferred backing materials 24 include flexible resilient polymeric open cell foams, and fabrics of polyester, cotton, and/or nylon can be impregnated into the foams.

The thickness of each of the base layer 24 and binder layer 22 may range between 1 to 100 mm, more preferably between about 2 to 5 mm. As the fiber major axis length increases, thicker binder layers are preferred.

### Gloss Measurement

The following general procedure was used to measure the gloss of a surface being polished. The surface was first dried to remove any residual water or polishing compound. A glossmeter known under the trade designation "Micro-Tri-Gloss", Catalog No. 4525, commercially available from BYK Gardner Inc., Silver Spring, Maryland, was used. The 20° and 60° glossmeter geometry gloss measurements were made after abrading with the articles described in the examples. The gloss value reported was the average of 9 readings per tile on 3 separate tiles.

Test method ASTM D-523 was followed for determining specular gloss values. Note that "60° gloss meter geometry gloss" value (i.e, incident light reflected from the test surface at instant angle measured 60° from vertical) related to the "shininess" of the surface and correlated to the appearance of the floor about 3 meters in front of the observer. A "20° gloss meter geometry gloss" value related to the depth of the reflection and correlated to the appearance of the floor about 60 cm in front of the observer. The reading off a glossmeter is an indexed value, with a value of "100" given to the glossmeter reading (from any angle) from a highly polished, plane, black glass with a refractive index of 1.567 for the sodium D line. The incident light was supplied by the tester itself. A value of 0 to about 10 is no or very low gloss, while "high gloss" at 60° geometry is about 60 or greater; a value of 0 to about 5 is no or very low gloss, while high gloss at 20° geometry is about 20 or greater.

### Examples

### EXAMPLE 1' AND COMPARATIVE EXAMPLE A'

Example 1' and Comparative Example A' show the efficacy of the brushes made in accordance with the Alternate Brush Making Method for cleaning copper laminate for use in printed circuit boards in preparation for further processing.

The brush of Example 1' was constructed from sheet material made in accordance with the Alternate Brush Making Method described above. Abrasive fibers having 0.305 mm major axis length (diameter) and length of 15 mm comprised of nylon 6,12 ("CR9", available from EMS Chemie, AG, Zurich, Switzerland) containing 30% by weight grade 320 silicon carbide abrasive particles were prepared by the fiber making process above-described (drawn using a 3:1 draw ratio). These abrasive fibers were flocked into a 55 cm wide by 2.5 cm thick layer of polyurethane prepolymer resin known under the trade designation "Adiprene 5333", available from Uniroyal Chemical Company, Middlebury, CT and allowed to cure. The polyurethane prepolymer resin used was a diphenylmethane-4,4'-diisocyanate based polyether urethane prepolymer. The resulting carpet-like sheet of brush material was cut into 30 cm wide strips and helically wrapped about a 67 mm internal diameter by 2 mm wall thickness steel tube at an angle to make 19 turns per each 61 cm length of tube to form a cylindrical brush. Upon securing the ends of the strips and cutting the brush to the desired length, a brush of overall dimensions 6.7 cm internal diameter by 10.2 cm outside diameter by 120 cm long brush was obtained.

The brush of Comparative Example A' was made identically to Example 1' with the exception that the abrasive fibers were commercially available 0.559 mm diameter fibers comprising nylon 6,12 containing grade 320 (average particle size about 34 micrometers) silicon carbide abrasive particles ("TYNEX", available from E.I. DuPont de Nemours & Company, Inc., Wilmington, DE).

The brushes of Example 1' and Comparative Example A' were evaluated for cleaning copper laminates for use in printed circuit boards. The brushes were operated at 2800 surface feet per minute. The resulting surface profile characteristics are shown in Table A.

**Table A**

| Property | Example 1' | Comparative Example A' |
|---|---|---|
| average roughness, Rₐ (micrometers) | 0.18 | 0.24 |
| average roughness depth, R_{z} (micrometers) | 1.3 | 2.1 |
| maximum profile depth, Pₜ | 2.5 | 3.3 |

These data demonstrated that the methods of the present invention treated the copper laminates more uniformly and left smaller scratches than Comparative Example A', thereby leaving a good surface finish for subsequent process steps.

### EXAMPLE 2' AND COMPARATIVE EXAMPLE B'

Example 2' illustrates the benefits of the present invention when used to "defuzz" functional and/or decorative deep cuts or grooves in wood or particle board. Prior to the present invention, there was no truly efficacious method to remove sliver and fuzz from such cuts or grooves uniformly without deformation of the design lines and/or leaving scratch patterns. Previous methods included use converted forms of coated abrasives known as "wolfsheads" and "fladder blades", and nonwoven abrasive brushes (of the type disclosed in Hoover et al.) and wheels.

The brush of Example 2' was constructed of 0.305 mm major axis length (diameter) by 127 mm long abrasive fibers of nylon 6,6 ("ZYTEL FE3677", available from E.I. DuPont de Nemours & Company, Inc., Wilmington, DE) containing 30% by weight grade 320 (34 micrometer average particle size) silicon carbide abrasive particles prepared by the fiber making method above-described (drawn at 3:1 draw ratio). 152 mm wide fiber assemblies were made in accordance with the General Segmented Brush Making Method. 20 brush segment assemblies were installed on a 102 mm diameter hub known under the trade designation "RX" to complete the 152 mm wide brush. This brush was employed to defuzz decorative recesses in medium density fiberboard cabinet doors. The brush was driven at 700 rpm using a hand-held tool. This brush uniformly defuzzed the recesses without damage or dimension change to the recesses. Inside and outside 90 angle cuts were defuzzed and cleaned without beveling or other undesirable modification of the design.

In a separate comparative test, the brush of Example 2' was compared to Comparative Example B', which was identical to the brush of Example 2' with the exception that the abrasive fibers were "TYNEX" fibers of 0.559-mm major axis length (diameter) with grade 320 (34 micrometer average particle size) silicon carbide abrasive particles. In this case the workpiece was a louvered oak panel door. Previous methods using articles such as wolfsheads, fladder blades, and nonwoven abrasive brushes of the "Hoover et al."type could not defuzz the louvered areas. The comparative brush containing fibers known under the trade designation "TYNEX" was able to defuzz the louvered areas when operated against the workpiece at 700 rpm, but left undesirable cross-grain scratches on the surface. The brush of Example 2' was then evaluated at 700 rpm against another identical workpiece. This brush successfully removed all slivers and fuzz uniformly, did not deform the louver edges, and produced no cross-grain scratches even though it contained a coarser grade of abrasive particles.

### EXAMPLE 3' AND COMPARATIVE EXAMPLE C'

Example 3' shows the utility of the brushes of the present invention when used to clean and polish intricate metallic castings, such as those of pewter.

Metallic castings, such as those for use in small appliances, statuary, jewelry, and the like generally require a cleaning and polishing step after removal from the mold. Typically, this cleaning and polishing step has been accomplished through the use of nonwoven abrasive discs of the "Hoover et al." type. Such discs work well on planar or gently-curved surfaces, but suffer in performance when employed against intricate parts with long, narrow protrusions and severe relief. When operating on such workpieces, nonwoven abrasive discs tend to fail prematurely due to repeated flexing in confined spaces and suffer high wear due to repeated encounters with acute angles.

Brushes of Example 3' and Comparative Example C' were identical to those of Example 2' and Comparative Example B', respectively, with the exception that the brushes were only 102 mm wide. These brushes were tested against various pewter castings of horses, unicorns, dragons, locomotives, and the like.

When Comparative Example C' was employed at 700 rpm, the surface appeared clean and free of residual oxides. However, there were irregular scratch marks on the surface and relatively flat surfaces were not lustrous. When Example 3' was employed identically on such workpieces, the resulting castings were clean, free of oxides and scratches, and polished to a significantly higher level than those treated with the comparative brush.

### Examples 1-4 and Comparative Example A: Articles Wherein Individual Fibers Are Anchored in a Polymeric Bed of Resin (Brushes), Dry Buffing

Articles of the invention wherein individual fibers were anchored in a polymeric resin and the resin in turn adhered to a substrate (i.e. a brush) were attached via hook-and-loop attachment fasteners to a standard floor maintenance machine adapted to rotate at speeds ranging from 175 rpm to about 2500 rpm. The brushes were used to dry buff composition vinyl tiles coated with a standard metal-crosslinked acrylate floor finish which had been dulled to simulate wear of the finish. The improvement in gloss was measured at two angles, 20° and 60°, after about 6 seconds of dry buffing. A noninventive floor pad was also tested as Comparative Examples A1 and A2, known under the trade designations "51 Line Red Buffer Pad" (A1) and "Top Line Speed Burnish Pad" (A2), both from 3M, and both using 50 denier fibers. The pads of Comparative Examples A1 and A2 were made in accordance with Hoover et al., U.S. Pat. No. 2,958,593. The binders used to bind the fibers together in the pads of the comparative examples were identical except that the binder used in the pad of Comparative Example A1 had flint and calcium carbonate dispersed therein. The compositions of the fibers used in the articles of Examples 1-4 and Comparative Example A, as well as the improvement in gloss achieved with these articles are given in Tables 1-4 at various machine speeds.

**TABLE I**

| (175 rpm, dry buff) | | | |
|---|---|---|---|
| Example | Product* | Improvement in: 20° Gloss | Improvement in: 60° Gloss |
| Comp. Ex. A1 | Standard pad | 4 | 16 |
| 1 | 1 mm SiC Brush | 5 | 18 |
| 2 | 3 mm SiC Brush | 7 | 23 |
| 3 | 3 mm A1₂O₃ Brush | 7 | 27 |
| 4 | 10 mm Garnet Brush | 8 | 26 |

| | | | |
|---|---|---|---|
| ∗ Each brush included polyester fibers which were nylon 6, 12 having the indicated abrasive. In each case the weight percent abrasive in each fiber was about 30 %. The standard pad "A1" comprised a lofty, open, three-dimensional web of 50 denier polyester fibers which had flint and calcium carbonate particles adhered thereto with a styrene-butadiene rubber (SBR) binder. The standard pad "A2" was a lofty, open, three-dimensional speed burnish pad comprised 50 denier polyester fibers adhered together using the same SBR binder, but had no flint or calcium carbonate particles bound thereto. The A2 pad is generally described in U.S. Pat. No. 5,030,496. | | | |

**TABLE II**

| (300 rpm, dry buff) | | | |
|---|---|---|---|
| Example | Product* | Improvement in: 20° Gloss | Improvement in: 60° Gloss |
| Comp. Ex. A1 | Standard pad | 2 | 10 |
| 1 | 1 mm SiC Brush | -2 | 10 |
| 2 | 3 mm SiC Brush | 3 | 16 |
| 3 | 3 mm A1₂O₃ Brush | -1 | 11 |
| 4 | 10 mm Garnet Brush | 3 | 19 |

| | | | |
|---|---|---|---|
| ∗ See note to Table I | | | |

**TABLE III**

| (1500 rpm, dry buff) | | | |
|---|---|---|---|
| Example | Product* | Improvement in: 20° Gloss | Improvement in: 60° Gloss |
| Comp. Ex. A2 | Standard pad | 30 | 40 |
| 1 | 1 mm SiC Brush | 27 | 43 |
| 2 | 3 mm SiC Brush | 36 | 50 |
| 3 | 3 mm A1₂O₃ Brush | 30 | 43 |
| 4 | 10 mm Garnet Brush | 33 | 47 |

| | | | |
|---|---|---|---|
| ∗ See note to Table I | | | |

**TABLE IV**

| (2500 rpm, dry buff) | | | |
|---|---|---|---|
| Example | Product* | Improvement in: 20° Gloss | Improvement in: 60° Gloss |
| Comp. Ex. A2 | Standard pad | 38 | 40 |
| 1 | 1 mm SiC Brush | 30 | 43 |
| 2 | 3 mm SiC Brush | 27 | 38 |
| 3 | 3 mm A1₂O₃ Brush | 25 | 38 |
| 4 | 10 mm Garnet Brush | N/A | N/A |

| | | | |
|---|---|---|---|
| ∗See note to Table I | | | |

As can be seen by the results of dry buffing given in Tables I-IV, the brushes of the invention gave dry buffing results that had equivalent or greater improvements in gloss at both angles measured at 175, 300, and 1500 rpm machine speeds. At the speed of 2500 rpm (Table IV) the 60° gloss was equivalent or greater than the Comparative Example A.

### Examples 5-8 and Comparative Example B: Spray Buffing at 175 rpm

The brushes of Examples 5-8 were identical to the brushes of Examples 1-4 and the brush of Comparative Example B was identical to the brush of Comparative Example A1. The brushes of Examples 5-8 and Comparative Example B were evaluated on composition vinyl tiles coated with a metal-crosslinked acrylate finish and dulled to simulate wear and then spray buffed using a standard cleaning/polishing solution known under the trade designation "3M Spray Buff Cleaner and Polish", which comprised a mixture of water, a surfactant, and an organic solvent. The compositions of fibers of the articles and the results of improvement in gloss at 20° and 60° when used in spray buffing at 175 rpm are shown in Table V. The brushes of Examples 5-8 gave results superior to that the Comparative Example B, a standard floor pad as used in Comparative Example A1.

The brushes of Examples 5-8 were also evaluated for removal of heel marks from a coated floor. A first set of tiles coated with a metal-crosslinked acrylate finish were prepared and subsequently marked with simulated heel marks and were then dry buffed with the brushes of Examples 5-8, and Comparative Example B. A second set acrylic-coated tiles were spray buffed using the brushes and buffing composition used in Examples 5-8 and Comparative Example B to determine mark removal. Again, the brushes of Examples 5-8 performed as well as the standard floor pads of Comparative Example B in dry and spray buffing to remove heel marks.

**TABLE V**

| (175 rpm Spray Buff) | | | |
|---|---|---|---|
| Example | Product* | Improvement in: 20° Gloss | Improvement in: 60° Gloss |
| Comp. Ex. B | Standard pad | 5 | 16 |
| 5 | 1 mm SiC Brush | 3 | 26 |
| 6 | 3 mm SiC Brush | 12 | 34 |
| 7 | 3 mm A1₂O₃ Brush | 10 | 28 |
| 8 | 10 mm Garnet Brush | 12 | 32 |

| | | | |
|---|---|---|---|
| ∗ Standard pad same as Comparative Example A2 | | | |

### Examples 9-12 and Comparative Examples C, D, and E: Tufted Abrasive Articles, High Speed Burnishing

The abrasive articles of this set of examples comprised a texturized yarn of fibers tufted into a backing to form a pad. The abrasive fibers used in the examples of the invention were made of polyethylene terephthalate (PET) as the polymer and aluminum oxide abrasive particles, with a cut loop pattern. Table VI gives the composition of the fibers of the articles of the invention, the brand name of the metal-crosslinked acrylate floor finish used, and the change in gloss in 20° and 60° gloss meter reading.

The floor finishes known under the trade designations "Stellar" and "Stance" are available from Minnesota Mining and Manufacturing Co., St. Paul, MN. The floor finish known under the trade designation "Total Eclipse" is available from Pioneer Eclipse Company, Spartanburg, NC.

**TABLE VI**

| (2000 rpm Propane Burnishing Machine on Dulled Floor Finish, Measurement of the Improvement in Gloss) | | | | |
|---|---|---|---|---|
| Example | Floor finish and pad construction | # of Passes | Increase in Gloss: | |
| Comp. Ex. C | | | 20° | 60° |
| | "Stellar" | | | |
| | Speed Burnish pad* | 1 | 25 | 35 |
| | | 2 | 33 | 43 |
| 9 | Tufted - PET, 30% 3 mm Al₂0₃ | 1 | 34 | 37 |
| | | 2 | 41 | 42 |
| 10 | Tufted - PET, 30% 10 mm Al₂0₃ | 1 | 21 | 28 |
| | | 2 | 28 | 36 |
| Comp. Ex. D | "Stance" | | | |
| | Speed Burnish pad* | 1 | 17 | 25 |
| | | 2 | 24 | 33 |
| 11 | Tufted-PET, 30% 10 mm Al₂0₃ | 1 | 19 | 29 |
| | | 2 | 27 | 39 |
| Comp. Ex. E | "Total Eclipse" | | | |
| | Speed Burnish pad* | 1 | 24 | 28 |
| | | 2 | 33 | 36 |
| 12 | Tufted-PET, 30% 10 mm Al₂0₃ | 1 | 31 | 31 |
| | | 2 | 37 | 36 |

| | | | | |
|---|---|---|---|---|
| ∗ Same nonwoven pad as Comparative Example A2 | | | | |

The tufted pad having abrasive fibers containing 3 micrometer (mm) average particle size Al₂O₃ abrasive particles gave a better image clarity (20° gloss) than did the standard red speed burnish floor pad used. The 60° gloss was comparable. The tufted pad having abrasive fibers containing 10 mm Al₂O₃ did not perform as well.

### Examples 13 and 14 and Comparative Examples F and G: Tufted Articles, Electric Machine, High Speed Burnishing

An electric buffing machine was used with the tufted abrasive articles described in Table VII on a dulled floor finish. The composition of the fibers of articles of Examples 13 and 14 and Comparative Examples F and G are shown in Table VII and the improvement in 20° and 60° gloss is also shown. In Table VII, "PET" stands for polyethylene terephthalate.

**TABLE VII**

| (2000 rpm Clarke Cord Electric Buffing Machine on Dulled Floor Finish) | | | | |
|---|---|---|---|---|
| Example | Floor finish and Nonwoven Composition | # of Passes | Increase in Gloss: | |
| Comp. Ex. F | | | 20° | 60° |
| | "Stance" | | | |
| | Speed Burnish pad* | 1 | 4 | 11 |
| | | 2 | 8 | 20 |
| 13 | Tufted-PET, 30% 3 mm Al₂O₃ | 1 | 9 | 21 |
| | | 2 | 15 | 31 |
| Comp. Ex. G | "Total Eclipse" | | | |
| | Speed Burnish pad* | 1 | 4 | 8 |
| | | 2 | 8 | 15 |
| 14 | Tufted-PET, 30% 3 mm Al₂O₃ | 1 | 15 | 21 |
| | | 2 | 22 | 29 |

| | | | | |
|---|---|---|---|---|
| ∗ Same pad as used in Comparative Example A2 | | | | |

The tufted abrasive articles gave results which were much better than the comparative abrasive articles using an electric buffing machine on a dulled floor finish.

### Examples 15-20, and Comparative Examples H-L: Nonwoven Webs Comprising Microabrasive Filled Fibers

Open, lofty, lightweight nonwoven abrasive articles, 43 cm in diameter, were prepared and attached to a standard rotary floor maintenance machine. The inventive nonwovens abrasive articles had the following compositions (all employed polyethylene terephthalate as the fiber polymer):
Examples 15 and 16, "MAF Web (1x2581 lot 2)" means the fibers comprised 3 micrometer average particle size aluminum oxide abrasive grains dispersed in the polyester;
Examples 17 and 18, "MAF Web (1x2581 lot 3)" means the fibers comprised 20 micrometer average particle size aluminum oxide abrasive grains dispersed in the polyester;
Example 19, "MAF Web (1x2581 lot 1)" means the fibers comprised 3 micrometer average particle size aluminum oxide abrasive grains dispersed in polyester; and
Example 20, "MAF Web (1x2581 lot 4)" means the fibers comprised 20 micrometer average particle size aluminum oxide abrasive grains dispersed in the polyester.

**TABLE VIII**

| (Ultra High Speed Polishing - 2500 rpm on a Dulled Acrylate Floor Finish. Initial Glosses: 20° = 10 Gloss Units, 60° = 30.) | | | |
|---|---|---|---|
| | | One Pass Increase in Gloss | |
| Example | Web Construction | 20° | 60° |
| H | Comp. Ex. A2 | 5 | 9 |
| 15 | MAF Web (1x2581 lot 2) | 15 | 18 |

**TABLE IX**

| (300 rpm Spray Buffing on Dulled Acrylate Floor Finish. Initial Glosses: 20° = 10 Gloss Units, 60° = 30. Change in Gloss.) | | | |
|---|---|---|---|
| | | One Pass Increase in Gloss | |
| Example | Web Construction | 20° | 60° |
| I | Comp. Ex. A2 | 7 | 20 |
| 16 | MAF Web (1x2581 lot 2) | 11 | 26 |

**TABLE X**

| 300 rpm Scrubbing - Black Heel Mark Removal (BHM) BHM (0 = Poor, 5 = No Marks) | | |
|---|---|---|
| Example | Construction | BHM |
| J | Standard floor pad | 5 |
| 17 | MAF Web (1x2581 lot 3) | 5 |

**TABLE XI**

| Autoscrubbing - Change in Gloss, Black Heel Mark Removal (BHM). Initial Glosses: 20° = 15, 60° = 50. Initial Black Mark = 0 (Poor) | | | | |
|---|---|---|---|---|
| | | Change in Gloss | | BHM |
| Ex. | Construction | 20° | 60° | |
| Comp. Ex. K | light duty preburnish pad¹ | 0 | -2 | 4.0 |
| Comp. Ex. L | blue cleaning pad² | -2 | -10 | 2.0 |
| 18 | MAF Web (1x2581 lot 3) | 0 | -1 | 3.5 |
| 19 | MAF Web (1x2581 lot 1) | 1 | 3 | 3.0 |
| 20 | MAF Web (1x2581 lot 4) | -1 | -5 | 3.0 |

| | | | | |
|---|---|---|---|---|
| ¹ available from 3M under the trade designation "3M Brand Top Line PreBurnish Floor Pad" | | | | |
| ² available from 3M under the trade designation "Scotch- Brite Brand 51 Line Blue Cleaner Floor Pad" | | | | |

A difference of 5 gloss units is noticeable. A difference of 0.5 in BHM is noticeable, and a value of "5" in the BHM test designated "no heal marks left". The nonwoven abrasive articles of the present invention performed equally or better than the comparative example abrasive articles in the tests run herein.

Various modifications of the invention may become apparent to those skilled in the art. The description and examples presented herein are merely descriptive of the invention and are not intended to limit the invention or the appended claims in any way.

## Claims

1. A method of increasing the gloss of a surface, the method comprising bringing into frictional contact with the surface an abrasive article comprising a plurality of fibers (15, 20, 31, 37, 43, 61) comprising thermoplastic polymer filled with microabrasive particles having an average particle size not greater than 10 micrometers, for a time sufficient to increase the gloss of the surface, characterized in that the fibers (15, 20, 31, 37, 43, 61) each comprise a single layer of thermoplastic polymer with said microabrasive particles substantially dispersed, adhered and engulfed therein, said abrasive particles having an average particle size ranging from about 3 to about 10 micrometers, each fiber (15, 20, 31, 37, 43, 61) having a length dimension a]!d a transverse cross-section perpendicular to the length dimension, the transverse cross-section having major axis length ranging from about 0.25 to about 0.4 millimeter.

2. A method in accordance with claim 1 wherein said thermoplastic polymer is selected from the group consisting of polyamide, polypropylene, polyester, and thermoplastic elastomers.

3. A method in accordance with claim 1 wherein the abrasive particles are present in a weight percent based on weight of said fibers ranging from about 10 to about 30 weight percent.

4. A method in accordance with claim 1 wherein said article is a lofty, open, three-dimensional nonwoven abrasive article comprising said microabrasive-filled fibers.

5. A method in accordance with claim 1 wherein the thermoplastic polymer is polyethylene terephthalate.

6. A method in accordance with claim 1 wherein the abrasive article is a tufted abrasive article comprising a plurality of tufts of said microabrasive-filled fibers attached to a backing.

7. A method in accordance with claim 6 wherein the thermoplastic polymer is polyethylene terephthalate.

8. A method in accordance with claim 1 wherein said abrasive article comprises a plurality of microabrasive-filled fibers having first and second ends, the first ends being anchored to a backing.

9. A method in accordance with claim 8 wherein the thermoplastic polymer is nylon 6,12.

10. A method of removing undesirable material from a surface, the method comprising bringing into frictional contact with the surface an abrasive article comprising a plurality of fibers (15, 20, 31, 37, 43, 61) filled with microabrasive particles, for a time sufficient to remove the undersirable material from the surface, characterized in that the fibers (15, 20, 31, 37, 43, 61) each comprise a single layer of a thermoplastic polymer with abrasive particles substantially dispersed, adhered and engulfed therein, said abrasive particles having all average particle size ranging from about 15 to about 45 micrometers, each fiber (15, 20, 31, 37, 43, 61) having a length dimension and a transverse cross-section perpendicular to the length dimension, the transverse cross-section having major axis length ranging from about 0.1 to about 0.5 millimeter.

11. A method in accordance with claim 10 wherein said thermoplastic polymer is selected from the group consisting of polyamide, polypropylene, polyester, and thermoplastic elastomers.

12. A method in accordance with claim 10 wherein the abrasive particles are present in a weight percent based on weight of said fibers ranging from about 10 to about 30 weight percent.

13. A method in accordance with claim 10 wherein said article is a lofty, open, three-dimensional nonwoven abrasive article comprising said microabrasive-filled fibers.

14. A method in accordance with claim 11 wherein the polyester is polyethylene terephthalate.

15. A method in accordance with claim 10 wherein the abrasive article is a tufted abrasive article comprising a plurality of tufts of said microabrasive-filled fibers attached to a backing.

16. A method in accordance with claim 10 wherein said abrasive article comprises a plurality of microabrasive-filled fibers having first and second ends, the first ends being anchored to a backing.

17. A method in accordance with claim 11 wherein the polyamide is nylon 6,12.

## Patentansprüche

1. Verfahren zur Erhöhung des Glanzes einer Oberfläche, wobei das Verfahren das reibende In-Berührung-Bringen eines Schleifgegenstandes, umfassend eine Vielzahl von Fasern (15, 20, 31, 37, 43, 61), die ein mit Mikro-Schleifmittelteilchen mit einer mittleren Teilchengröße von nicht mehr als 10 µm gefülltes, thermoplastisches Polymer umfassen, mit der Oberfläche für einen Zeitraum umfaßt, der ausreichend ist, um den Glanz der Oberfläche zu vergrößern, dadurch gekennzeichnet, daß die Fasern (15, 20, 31, 37, 43, 61) jeweils eine einzige Schicht aus thermoplastischem Polymer umfassen, in dem die Mikro-Schleifmittelteilchen im wesentlichen dispergiert sind, an dem sie haften und in das sie eingebettet sind, wobei die Schleifmittelteilchen eine mittlere Teilchengröße aufweisen, die von etwa 3 bis etwa 10 µm reicht, jede Faser (15, 20, 31, 37, 43, 61) eine Länge und einen senkrecht zur Länge verlaufenden Querschnitt aufweist, wobei der Querschnitt eine Hauptachse aufweist, deren Länge von etwa 0,25 bis etwa 0,4 mm reicht.

2. Verfahren nach Anspruch 1, wobei das thermoplastische Polymer aus der aus Polyamid, Polypropylen, Polyester und thermoplastischen Elastomeren bestehenden Gruppe ausgewählt ist.

3. Verfahren nach Anspruch 1, wobei die Schleifmittelteilchen mit einem Gewichtsprozentwert, bezogen auf das Gewicht der Fasern, vorhanden sind, der von etwa 10 bis etwa 30 Gew.-% reicht.

4. Verfahren nach Anspruch 1, wobei der Gegenstand ein locker-elastischer, offener, dreidimensionaler, nichtgewebter Schleifgegenstand ist, der die mit Mikroschleifmittel gefüllten Fasern umfaßt.

5. Verfahren nach Anspruch 1, wobei das thermoplastische Polymer Polyethylenterephthalat ist.

6. Verfahren nach Anspruch 1, wobei der Schleifgegenstand ein büscheliger Schleifgegenstand ist, der eine Mehrzahl von Büscheln der mit Mikroschleifmittel gefüllten Fasern umfaßt, die an einem Träger befestigt sind.

7. Verfahren nach Anspruch 6, wobei das thermoplastische Polymer Polyethylenterephthalat ist.

8. Verfahren nach Anspruch 1, wobei der Schleifgegenstand eine Mehrzahl von mit Mikroschleifmittel gefüllten Fasern umfaßt, die ein erstes und ein zweites Ende aufweisen, wobei die ersten Enden an einem Träger verankert sind.

9. Verfahren nach Anspruch 8, wobei das thermoplastische Polymer Nylon 6,12 ist.

10. Verfahren zur Entfernung unerwünschten Materials von einer Oberfläche, wobei das Verfahren das reibende In-Berührung-Bringen eines Schleifgegenstandes, umfassend eine Vielzahl von mit Mikro-Schleifmittelteilchen gefüllten Fasern (15, 20, 31, 37, 43, 61), mit der Oberfläche für einen Zeitraum umfaßt, der ausreichend ist, um das unerwünschte Material von der Oberfläche zu entfernen, dadurch gekennzeichnet, daß die Fasern (15, 20, 31, 37, 43, 61) jeweils eine einzige Schicht aus thermoplastischem Polymer umfassen, in dem die Schleifmittelteilchen im wesentlichen dispergiert sind, an dem sie haften und in das sie eingebettet sind, wobei die Schleifmittelteilchen eine mittlere Teilchengröße aufweisen, die von etwa 15 bis etwa 45 µm reicht, jede Faser (15, 20, 31, 37, 43, 61) eine Länge und einen senkrecht zur Länge verlaufenden Querschnitt aufweist, wobei der Querschnitt eine Hauptachse aufweist, deren Länge von etwa 0,1 bis etwa 0,5 mm reicht.

11. Verfahren nach Anspruch 10, wobei das thermoplastische Polymer aus der aus Polyamid, Polypropylen, Polyester und thermoplastischen Elastomeren bestehenden Gruppe ausgewählt ist.

12. Verfahren nach Anspruch 10, wobei die Schleifmittelteilchen mit einem Gewichtsprozentwert, bezogen auf das Gewicht der Fasern, vorhanden sind, der von etwa 10 bis etwa 30 Gew.-% reicht.

13. Verfahren nach Anspruch 10, wobei der Gegenstand ein locker-elastischer, offener, dreidimensionaler, nichtgewebter Schleifgegenstand ist, der die mit Mikroschleifmittel gefüllten Fasern umfaßt.

14. Verfahren nach Anspruch 11, wobei der Polyester Polyethylenterephthalat ist.

15. Verfahren nach Anspruch 10, wobei der Schleifgegenstand ein büscheliger Schleifgegenstand ist, der eine Mehrzahl von Büscheln der mit Mikroschleifmittel gefüllten Fasern umfaßt, die an einem Träger befestigt sind.

16. Verfahren nach Anspruch 10, wobei der Schleifgegenstand eine Mehrzahl von mit Mikroschleifmittel gefüllten Fasern umfaßt, die ein erstes und ein zweites Ende aufweisen, wobei die ersten Enden an einem Träger verankert sind.

17. Verfahren nach Anspruch 11, wobei das Polyamid Nylon 6,12 ist.

## Revendications

1. Un procédé pour améliorer le poli d'une surface, le procédé comprenant les étapes consistant à mettre la surface en contact de friction avec un article abrasif comprenant une pluralité de fibres (15, 20, 31, 37, 43, 61) contenant un polymère thermoplastique rempli de particules abrasives dont la taille des particules moyenne n'excède pas 10 microns, pendant un temps suffisant pour améliorer le poli de la surface, caractérisé en ce que les fibres (15, 20, 31, 37, 43, 61) comprennent chacune une couche unique de polymère thermoplastique, lesdites particules microabrasives étant substantiellement dispersées, collées et englobées à l'intérieur, lesdites particules abrasives ayant une taille de particules moyenne comprise dans la gamme allant d'environ 3 à environ 10 microns, chaque fibre (15, 20, 31, 37, 43, 61) présentant une dimension longitudinale et une coupe transversale perpendiculaire à la dimension longitudinale, la coupe transversale ayant une longueur d'axe majeur comprise dans la gamme allant d'environ 0,25 à environ 0,4 mm.

2. Un procédé selon la revendication 1, dans lequel ledit polymère thermoplastique est sélectionné parmi le groupe composé de polyamide, de polypropylène, de polyester et d'élastomères thermoplastiques.

3. Un procédé selon la revendication 1, dans lequel les particules abrasives sont présentes selon un pourcentage en masse sur la base de la masse desdites fibres compris dans la gamme allant d'environ 10 à environ 30 pour-cent en masse.

4. Un procédé selon la revendication 1, dans lequel ledit article est un article abrasif non tissé en trois dimensions, ouvert, à torsion floche et comprenant lesdites fibres remplies de matière microabrasive.

5. Un procédé selon la revendication 1, dans lequel le polymère thermoplastique est du téréphtalate de polyéthylène.

6. Un procédé selon la revendication 1, dans lequel l'article abrasif est un article abrasif tufté comprenant une pluralité de touffes desdites fibres remplies de matière microabrasive fixées à un support.

7. Un procédé selon la revendication 6, dans lequel le polymère thermoplastique est du téréphtalate de polyéthylène.

8. Un procédé selon la revendication 1, dans lequel ledit article abrasif comprend une pluralité de fibres remplies de matière microabrasive présentant des premières et secondes extrémités, les premières extrémités étant plantées sur un support.

9. Un procédé selon la revendication 8, dans lequel le polymère thermoplastique est du nylon 6,12.

10. Un procédé pour éliminer d'une surface une matière indésirable, le procédé comprenant les étapes consistant à mettre la surface en contact de friction avec un article abrasif comprenant une pluralité de fibres (15, 20, 31, 37, 43, 61) remplies de particules microabrasives, pendant un temps suffisant pour éliminer de la surface la matière indésirable, caractérisé en ce que les fibres (15, 20, 31, 37, 43, 61) comprennent chacune une couche unique d'un polymère thermoplastique, avec des particules abrasives substantiellement dispersées, collées et englobées à l'intérieur, lesdites particules abrasives ayant une taille de particules moyenne comprise dans la gamme allant d'environ 15 à environ 45 microns, chaque fibre (15, 20, 31, 37, 43, 61) présentant une dimension longitudinale et une coupe transversale perpendiculaire à la dimension longitudinale, la coupe transversale ayant une longueur d'axe majeur comprise dans la gamme allant d'environ 0,1 à environ 0,5 mm.

11. Un procédé selon la revendication 10, dans lequel ledit polymère thermoplastique est sélectionné parmi le groupe composé de polyamide, de polypropylène, de polyester et d'élastomères thermoplastiques.

12. Un procédé selon la revendication 10, dans lequel les particules abrasives sont présentes selon un pourcentage en masse sur la base de la masse desdites fibres compris dans la gamme allant d'environ 10 à environ 30 pour-cent en masse.

13. Un procédé selon la revendication 10, dans lequel ledit article est un article abrasif non tissé en trois dimensions, ouvert, à torsion floche comprenant lesdites fibres remplies de matière microabrasive.

14. Un procédé selon la revendication 11, dans lequel le polyester est du téréphtalate de polyéthylène.

15. Un procédé selon la revendication 10, dans lequel l'article abrasif est un article abrasif tutté comprenant une pluralité de touffes desdites fibres remplies de matière microabrasive fixées à un support.

16. Un procédé selon la revendication 10, dans lequel ledit article abrasif comprend une pluralité de fibres remplies de matière microabrasive présentant des premières et secondes extrémités, les premières extrémités étant plantées sur un support.

17. Un procédé selon la revendication 11, dans lequel le polyamide est du nylon 6,12.
